# EUROPEAN PATENT SPECIFICATION

(11) **EP 2 033 051 B1**
(45) Date of publication and mention of the grant of the patent: **30.11.2016**
(21) Application number: 07809499.2
(22) Date of filing: 13.06.2007
(51) Int. Cl.: G03F 7/085

(54) **NEGATIVE-WORKING IMAGEABLE ELEMENTS**
NEGATIVE ABBILDBARE ELEMENTE
ÉLÉMENTS IMAGEABLES NÉGATIFS

(30) Priority: 27.06.2006 US 475694
(43) Date of publication of application: 11.03.2009
(73) Proprietor: Eastman Kodak Company, Rochester, NY 14650-2201 (US)
(72) Inventor: MUNNELLY, Heidi M., Windsor, CO 80550 (US); SARAIYA, Shashikant, Fort Collins, CO 80528 (US); WIELAND, Kevin David, Greeley, CO 80634 (US); MIKELL, Frederic Eugene, Greeley, CO 80634 (US); WEST, Paul Richard, Fort Collins, CO 80526 (US)
(74) Representative: Vossius & Partner Patentanwälte Rechtsanwälte mbB
(86) International application number: PCT/US2007/013818
(87) International publication number: WO 2008/002393

(56) References cited:
- EP-A2- 1 500 498
- WO-A-2004/099876
- US-A1- 2003 194 654
- US-A1- 2004 260 050

## Description

### FIELD OF THE INVENTION

This invention relates to negative-working imageable elements such as negative-working lithographic printing plate precursors that can be imaged at lower energies. These imageable elements also can be developed either on-press or off-press without a post-exposure baking step. The invention also relates to methods of using these imageable elements for making a printing plate.

### BACKGROUND OF THE INVENTION

Radiation-sensitive compositions are routinely used in the preparation of imageable materials including lithographic printing plate precursors. Such compositions generally include a radiation-sensitive component, an initiator system, and a binder, each of which has been the focus of research to provide various improvements in physical properties, imaging performance, and image characteristics.

Recent developments in the field of printing plate precursors concern the use of radiation-sensitive compositions that can be imaged by means of lasers or laser diodes, and more particularly, that can be imaged and/or developed on-press. Laser exposure does not require conventional silver halide graphic arts films as intermediate information carriers (or "masks") since the lasers can be controlled directly by computers. High-performance lasers or laser-diodes that are used in commercially-available image-setters generally emit radiation having a wavelength of at least 700 nm, and thus the radiation-sensitive compositions are required to be sensitive in the near-infrared or infrared region of the electromagnetic spectrum. However, other useful radiation-sensitive compositions are designed for imaging with ultraviolet or visible radiation.

There are two possible ways of using radiation-sensitive compositions for the preparation of printing plates. For negative-working printing plates, exposed regions in the radiation-sensitive compositions are hardened and unexposed regions are washed off during development. For positive-working printing plates, the exposed regions are dissolved in a developer and the unexposed regions become an image.

Various radiation compositions and imageable elements containing reactive polymer binders are described in U.S. Patent 6,569,603 (Furukawa) and EP 1,182,033A1 (Fujimaki et al.). The reactive polymer binders include reactive vinyl groups that are pendant to the polymer backbone. Other IR-sensitive compositions are described in U.S. Patents 6,309,792 (Hauck et al.), 6,893,797 (Munnelly et al.), 6,787,281 (Tao et al.), and 6,899,994 (Huang et al.), U.S. Patent Application Publication 2003/0118939 (West et al.), and EP 1,079,276A1 (Lifka et al.) and EP 1,449,650A1 (Goto).

U.S. Patent Application Publication 2005-263021 (Mitsumoto et al.) describes negative-working lithographic compositions that may contain a phosphate acrylate that are allegedly developed on-press.

The art also teaches the incorporation of phosphate acrylates in radiation-sensitive composition for various purposes including copolymerization with other polymerizable monomers. In other instances, they are included as additives in combination with organoboron initiators, especially in visible- and UV-sensitive imaging compositions.

WO 2004/099876 A1 discloses a photosensitive resin composition which is alkali-soluble and comprises an acrylate resin. US 2004/0260050 A1 describes negative-working imageable elements. US 2003/0194654 A1 deals with a method for treating photosensitive lithographic printing plates. EP 1 500 498 A2 discloses a printing plate precursor comprising a compound with a functional group having an interaction with the surface of the hydrophilic support.

### Problem to be Solved

The various radiation sensitive compositions of the art can readily be used to prepare negative-working imageable elements but they generally require the use of a post-exposure baking step to enhance good adhesion and run length. Omitting the post-exposure baking step can result in complete image failure following development with alkaline developers or during on-press development.

This problem is more evident when the radiation-sensitive composition is used on a sulfuric acid anodized substrate. Imaged elements having such substrates are preferred by printers because they are less prone to scratching compared to other anodized substrates, and background sensitivity is reduced during long press runs. However, maintaining good image adhesion is a challenge for negative-working elements of this type. During long print runs, they may show a loss of highlight dots long before solid image areas show signs of wear or degradation.

It would be desirable in the industry to have highly sensitive negative-working imageable elements that provide good run length but that can also be prepared for use without a post-exposure baking step. It would also be desirable to have a radiation-sensitive imageable element that can be developed either off-press or on-press.

### SUMMARY OF THE INVENTION

This invention provides a negative-working imageable element comprising a substrate having thereon an imageable layer comprising:
a free radically polymerizable component,
an initiator composition capable of generating free radicals sufficient to initiate polymerization of the free radically polymerizable component upon exposure to imaging radiation,
a radiation absorbing compound,
a polymeric binder comprising a polymer backbone to which are directly or indirectly linked poly(alkylene glycol) side chains, and
a nonionic phosphate acrylate having a molecular weight of at least 250, wherein said nonionic phosphate acrylate is a nonionic phosphate di- or triacrylate that is present in said imageable layer in an amount of at least 8 and up to and including 300 mg/m²;
provided that when the element is exposed to imaging radiation having a λₘₐₓ of at least 250 nm and up to and including 450 nm, said polymeric binder further comprises pendant carboxy groups.

In some preferred embodiments of the imageable elements of this invention, the imageable elements are negative-working lithographic printing plate precursors comprising a roughened, sulfuric acid-anodized aluminum substrate having thereon a single imageable layer comprising:
a free radically polymerizable component that comprises a urethane acrylate, an ethoxylated Bisphenol A (di)(meth)acrylate, or both,
a triazine initiator composition capable of generating free radicals sufficient to initiate polymerization of the free radically polymerizable component upon exposure to infrared radiation, the triazine composition comprising a polyhalomethyl-substituted triazine, and N-phenyliminodiacetic acid or mercapto-3-triazole as a co-initiator,
an IR dye,
a polymeric binder comprising a polymer backbone to which are directly or indirectly linked poly(ethylene glycol) or poly(propylene glycol) side chains, and
a nonionic phosphate acrylate that is present in said imageable layer in an amount of at least 10 and up to and including 150 mg/m², the nonionic phosphate acrylate being one or more of
Kayamer PM-2, Kayamer PM-21, as these compounds are defined herein.

In other preferred embodiments, the imageable elements are negative-working, on-press developable lithographic printing plate precursors comprising a roughened, and sulfuric acid-anodized aluminum substrate having thereon a single imageable layer comprising:
a free radically polymerizable component that comprises a urethane acrylate, an ethoxylated Bisphenol A (di)(meth)acrylate, or both,
an iodonium salt initiator capable of generating free radicals sufficient to initiate polymerization of the free radically polymerizable component upon exposure to infrared radiation, and a mercaptotriazole co-initiator,
an IR dye,
a polymeric binder comprising a polymer backbone to which are directly or indirectly linked poly(ethylene glycol) or poly(propylene glycol) side chains, and
a nonionic phosphate acrylate that is present in said imageable layer in an amount of at least 10 and up to and including 150 mg/m², the nonionic phosphate acrylate being one or more of
Kayamer PM-2, Kayamer PM-21, as these compounds are defined herein.

In still other preferred embodiments, the imageable elements are negative-working lithographic printing plate precursors comprising a roughened, and sulfuric acid-anodized aluminum substrate having thereon an imageable layer comprising:
a free radically polymerizable component that comprises a urethane acrylate, an ethoxylated Bisphenol A (di)(meth)acrylate, or both,
a hexaarylbiimidazole initiator capable of generating free radicals sufficient to initiate polymerization of the free radically polymerizable component upon exposure to imaging radiation having a wavelength of at least 350 nm and up to and including 420 nm, and a thiol co-initiator,
a 2,4,5-triazryloxazole sensitizer,
a polymeric binder comprising a polymer backbone to which are directly or indirectly linked poly(ethylene glycol) or poly(propylene glycol) side chains, and
a nonionic phosphate acrylate that is present in the imageable layer in an amount of at least 10 and up to and including 150 mg/m², the nonionic phosphate acrylate being one or more of
Kayamer PM-2 (m = 1 or 2, n = 3 - m), Kayamer PM-21 (n = 2).

This invention also provides a method of making a negative-working printing plate comprising:
A) imagewise exposing a negative-working imageable element of this invention at an imaging radiation to produce exposed and non-exposed regions in the imageable layer, and
B) without a preheat step, developing the imagewise exposed element to remove only the non-exposed regions of the imageable layer.

The imageable elements of this invention provide imaged elements with excellent run length without the need for a post-exposure baking step. The resulting imaged elements exhibit improvements in highlight dot retention during the course of a long press run. These advantages are achieved no matter whether the imaged elements are developed "off-press" using alkaline developers or "on-press" using fountain solutions, lithographic printing inks, or mixtures thereof. These advantages are particularly noticeable using elements that include sulfuric acid anodized substrates.

Elimination of the post-exposure baking step reduces the number of pre-press variables that can affect image quality and reduces energy costs.

These advantages are achieved because of the inclusion in the imageable element of the nonionic phosphate acrylate described herein. These acrylates are not used in the formation of polymers. Rather, they are "additives" that unexpectedly provide the desired benefits in the negative-working compositions and imageable elements described and claimed herein.

### DETAILED DESCRIPTION OF THE INVENTION

### Definitions

Unless the context indicates otherwise, when used herein, the term "radiation-sensitive composition", "imageable element", and "printing plate precursor" are meant to be references to embodiments of the present invention.

In addition, unless the context indicates otherwise, the various components described herein such as "radically polymerizable component", "initiator", "co-initiator", "radiation absorbing compound", "polymeric binder", "nonionic phosphate acrylate", and similar terms also refer to mixtures of such components. Thus, the use of the articles "a", "an", and "the" is not necessarily meant to refer to only a single component.

The term "single-layer imageable element" refers to an imageable element having only one imageable layer that is essential to imaging, but as pointed out in more detail below, such elements may also include one or more layers under or over (such as a topcoat) the imageable layer to provide various properties.

Moreover, unless otherwise indicated, percentages refer to percents by dry weight.

For clarification of definitions for any terms relating to polymers, reference should be made to "Glossary of Basic Terms in Polymer Science" as published by the International Union of Pure and Applied Chemistry ("IUPAC"), Pure Appl. Chem. 68, 2287-2311 (1996). However, any definitions explicitly set forth herein should be regarded as controlling.

"Graft" polymer or copolymer refers to a polymer having a side chain that has a molecular weight of at least 200.

The term "polymer" refers to high and low molecular weight polymers including oligomers and includes homopolymers and copolymers.

The term "copolymer" refers to polymers that are derived from two or more different monomers.

The term "backbone" refers to the chain of atoms in a polymer to which a plurality of pendant groups are attached. An example of such a backbone is an "all carbon" backbone obtained from the polymerization of one or more ethylenically unsaturated polymerizable monomers. However, other backbones can include heteroatoms wherein the polymer is formed by a condensation reaction or some other means.

### Radiation-sensitive Compositions

The radiation-sensitive compositions are used to prepare the imageable elements of the present invention such as printed circuit boards for integrated circuits, microoptical devices, paint compositions, molding compositions, color filters, photomasks, and preferably printed forms such as lithographic printing plate precursors and imaged printing plates that are defined in more detail below.

The free radically polymerizable component present in the radiation-sensitive composition contains one or more compounds having any polymerizable group that can be polymerized using free radical initiation. For example, the free radically polymerizable component can contain one or more free radical polymerizable monomers or oligomers having one or more addition polymerizable ethylenically unsaturated groups, crosslinkable ethylenically unsaturated groups, a ring-opening polymerizable groups, azido groups, aryldiazonium salt groups, aryldiazosulfonate groups, or a combination thereof Similarly, crosslinkable polymers having such free radically polymerizable groups can also be used.

Suitable ethylenically unsaturated compounds that can be polymerized or crosslinked include ethylenically unsaturated polymerizable monomers that have one or more of the polymerizable groups, including unsaturated esters of alcohols, such as acrylate and methacrylate esters of polyols. Oligomers and/or prepolymers, such as urethane acrylates and methacrylates, epoxide acrylates and methacrylates, polyester acrylates and methacrylates, polyether acrylates and methacrylates, and unsaturated polyester resins can also be used. In some embodiments, the free radically polymerizable component comprises carboxy groups.

Particularly useful free radically polymerizable components include free-radical polymerizable monomers or oligomers that comprise addition polymerizable ethylenically unsaturated groups including multiple acrylate and methacrylate groups and combinations thereof, or free-radical crosslinkable polymers. More particularly useful radically polymerizable compounds include those derived from urea urethane (meth)acrylates or urethane (meth)acrylates having multiple polymerizable groups. For example, a most preferred free radically polymerizable component can be prepared by reacting DESMODUR^{®} N100 aliphatic polyisocyanate resin based on hexamethylene diisocyanate (Bayer Corp., Milford, Conn.) with hydroxyethyl acrylate and pentaerythritol triacrylate. is fi Other preferred free radically polymerizable compounds are available from Sartomer Company, Inc. such as SR399 (dipentaerythritol pentaacrylate), SR355 (di-trimethylolpropane tetraacrylate), SR295 (pentaerythritol tetraacrylate), and others that would be readily apparent to one skilled in the art.

Numerous other free radically polymerizable compounds are known to those skilled in the art and are described in considerable literature including Photoreactive Polymers: The Science and Technology of Resists, A Reiser, Wiley, New York, 1989, pp. 102-177, by B.M. Monroe in Radiation Curing: Science and Technology, S.P. Pappas, Ed., Plenum, New York, 1992, pp. 399-440, and in "Polymer Imaging" by A.B. Cohen and P. Walker, in Imaging Processes and Material, J.M. Sturge et al. (Eds.), Van Nostrand Reinhold, New York, 1989, pp. 226-262. For example, useful free radically polymerizable components are also described in EP 1,182,033A1 (noted above), beginning with paragraph [0170].

In some embodiments, the free radically polymerizable component comprises carboxy groups in an amount sufficient to provide an acid number greater than 0 mg KOH per grams of polymerizable component, and generally from 0 and up to and including 200 mg KOH per gram of the polymerizable component. Preferably, the acid number is from 0 and up to and including 100 mg KOH/gram of polymerizable component and more preferably, it is from 0 and up to and including 60 mg KOH/gram of polymerizable component.

Free radically polymerizable compounds containing carboxy groups can be prepared in a number of ways. For example, oligomers containing carboxy groups can be prepared as described in the teaching of Col. 4 (line 42) to Col. 5 (linel9) and Col. 7 (line 14) to Col. 8 (line 45) of U.S. Patent 4,228,232 (Rousseau). The carboxy groups can be added to the oligomers preferably after addition of the free radical polymerizable moieties by reaction of remaining hydroxy groups on the oligomer backbone with a compound having free carboxy groups (such as a dicarboxylic acid or anhydride). The resulting oligomers can be polymerized to provide a desired carboxy-substituted polymer.

Alternatively, a poly(urea urethane)acrylate or poly(urethane)acrylate can be prepared from the reaction of a diisocyanate with a diol having free carboxy groups similarly to the preparation of allyl functional polyurethanes described in U.S. Patent 5,919,600 (Huang et al.).

The free radically polymerizable component is present in the radiation-sensitive composition in an amount sufficient to render the composition insoluble in an aqueous developer after exposure to radiation. For example, the weight ratio of free radically polymerizable component to the polymeric binder (described below) is generally from 5:95 to 95:5, preferably from 10:90 to 90:10, and more preferably from 30:70 to 70:30. The free radically polymerizable component can be present in an amount of at least 10 and up to and including 70%, preferably at least 20 and up to and including 50%, based on the total solids in the radiation sensitive composition, or the total dry weight of the imageable layer.

The radiation-sensitive composition also includes an initiator composition that is capable of generating free radicals sufficient to initiate polymerization of the free radically polymerizable component upon exposure of the composition to imaging radiation. The initiator composition may be responsive, for example, to electromagnetic imaging radiation in the ultraviolet, visible and/or infrared spectral regions, corresponding to the spectral range of at least 150 nm and up to and including 1500 nm. UV and visible light sensitivity is generally at least 150 nm and up to and including 700 nm and in some embodiments, the radiation-sensitive composition is sensitive to imaging or exposing radiation of at least 250 nm and up to and including 450 nm (and preferably at least 375 nm and up to and including 450 nm) and includes an appropriate initiator composition for that imaging region. In other embodiments, the initiator composition is responsive to imaging or exposing infrared or near infrared radiation range of at least 600 nm and up to and including 1500 nm, and more preferably to imaging infrared radiation of at least 700 nm and up to and including 1200 nm and initiator compositions are used that are appropriate to that imaging range.

In general, suitable initiator compositions comprise compounds that include but are not limited to, amines (such as alkanol amines), thiol compounds, anilinodiacetic acids or derivatives thereof, N-phenyl glycine and derivatives thereof, N,N-dialkylaminobenzoic acid esters, N-arylglycines and derivatives thereof (such as N-phenylglycine), aromatic sulfonylhalides, trihalogenomethylsulfones, imides (such as N-benzoyloxyphthalimide), diazosulfonates, 9,10-dihydroanthracene derivatives, N-aryl, S-aryl, or O-aryl polycarboxylic acids with at least 2 carboxy groups of which at least one is bonded to the nitrogen, oxygen, or sulfur atom of the aryl moiety (such as aniline diacetic acid and derivatives thereof and other "co-initiators" described in U.S. Patent 5,629,354 of West et al.), oxime ethers and oxime esters (such as those derived from benzoin), α-hydroxy or α-amino-acetophenones, alkyltriarylborates, trihalogenomethylarylsulfones, benzoin ethers and esters, peroxides (such as benzoyl peroxide), hydroperoxides (such as cumyl hydroperoxide), azo compounds (such as azo bis-isobutyronitrile), 2,4,5-triarylimidazolyl dimers (also known as hexaarylbiimidazoles, or "HABI's") as described for example in U.S. Patent 4,565,769 (Dueber et al.), borate and organoborate salts such as those described in U.S. Patent 6,562,543 (Ogata et al.), and onium salts (such as ammonium salts, diaryliodonium salts, triarylsulfonium salts, aryldiazonium salts, and N-alkoxypyridinium salts). Other known initiator composition components are described for example in U.S Patent Application Publication 2003/0064318 (noted above).

Particularly useful initiator composition components for UV and visible light sensitive radiation-sensitive compositions include hexaarylbiimidazoles (also known as triarylimidazolyl dimers) such as, for example, 2,2'-bis(2-chlorophenyl)-4,4',5,5'-tetraphenyl-biimidazole and 2,2'-bis(*o*-chlorophenyl-4,4',5,5'-tetra(*m*-methoxyphenyl)biimidazole. The triazines noted below can be used with exposure to imaging radiation at about any wavelength including UV and visible radiation exposure.

Other UV radiation-sensitive free-radical generating compounds include but are not limited to, trichloromethyl triazines as described, for example, in U.S. Patent 4,997,745 (Kawamura et al.) and diaryliodonium salts.

Co-initiators can also be used, such as metallocenes (such as titanocenes and ferrocenes), polycarboxylic acids, haloalkyl triazines, thiols or mercaptans (such as mercaptotriazoles), borate salts, and photooxidants containing a heterocyclic nitrogen that is substituted by an alkoxy or acyloxy group, as described in U.S. Patent 5,942,372 (West et al.).

For IR-sensitive radiation-sensitive compositions, the preferred initiator compositions comprise an onium salt including but not limited to, a sulfonium, oxysulfoxonium, oxysulfonium, sulfoxonium, ammonium, selenonium, arsonium, phosphonium, diazonium, or halonium salt. Further details of useful onium salts, including representative examples, are provided in U.S. Patent Application Publication 2002/0068241 (Oohashi et al.), WO 2004/101280 (Munnelly et al.), and U.S. Patents 5,086,086 (Brown-Wensley et al.), 5,965,319 (Kobayashi), and 6,051,366 (Baumann et al.). For example, suitable phosphonium salts include positive-charged hypervalent phosphorus atoms with four organic substituents. Suitable sulfonium salts such as triphenylsulfonium salts include a positively-charged hypervalent sulfur with three organic substituents. Suitable diazonium salts possess a positive-charged azo group (that is -N=N⁺). Suitable ammonium salts include a positively-charged nitrogen atom such as substituted quaternary ammonium salts with four organic substituents, and quaternary nitrogen heterocyclic rings such as N-alkoxypyridinium salts. Suitable halonium salts include a positively-charged hypervalent halogen atom with two organic substituents. The onium salts generally include a suitable number of negatively-charged counterions such as halides, hexafluorophosphate, thiosulfate, hexafluoroantimonate, tetrafluoroborate, sulfonates, hydroxide, perchlorate, *n*-butyltriphenyl borate, tetraphenyl borate, and others readily apparent to one skilled in the art.

The halonium salts are more preferred, and the iodonium salts are most preferred. In one preferred embodiment, the onium salt has a positively-charged iodonium, (4-methylphenyl)[4-(2-methylpropyl)phenyl]- moiety and a suitable negatively charged counterion. A representative example of such an iodonium salt is available as Irgacure^{®} 250 from Ciba Specialty Chemicals (Tarrytown, NY) that is (4-methylphenyl)[4-(2-methylpropyl)phenyl]iodonium hexafluorophosphate and is supplied in a 75% propylene carbonate solution.

Particularly useful boron components include organic boron salts that include an organic boron anion such as those described in the noted U.S.

Patent 6,569,603 that is paired with a suitable cation such as an alkali metal ion, an onium, or a cationic sensitizing dye. Useful onium cations include but are not limited to, ammonium, sulfonium, phosphonium, iodonium, and diazonium cations. Iodonium salts and particularly iodonium borates are particularly useful as initiator compounds in radiation-sensitive compounds that are designed for "on-press" development (described in more detail below). They may be used alone or in combination with various co-initiators such as heterocyclic mercapto compounds including mercaptotriazoles, mercaptobenzimidazoles, mercaptobenzoxazoles, mercaptobenzothiazoles, mercaptobenzoxadiazoles, mercaptotetrazoles, such as those described for example in U.S. Patent 6,884,568 (Timpe et al.) that is cited herein in amounts of at least 0.5 and up to and including 10 weight % based on the total solids of the radiation-sensitive composition. The mercaptotriazoles are preferred in these combinations of compounds.

The preferred initiator compositions include one or more azine compounds as described for example in U.S. Patent 6,936,384 (Munnelly et al.). These compounds are organic heterocyclic compounds containing a 6-membered ring formed from carbon and nitrogen atoms. Azine compounds include heterocyclic groups such as pyridine, diazine, and triazine groups, as well as polycyclic compounds having a pyridine, diazine, or triazine substituent fused to one or more aromatic rings such as carbocyclic aromatic rings. Thus, the azine compounds include, for example, compounds having a quinoline, isoquinoline, benzodiazine, or naphthodiazine substituent. Both monocyclic and polycyclic azine compounds are useful.

Especially useful azine compounds are triazine compounds that include a 6-membered ring containing 3 carbon atoms and 3 nitrogen atoms such as those described in U.S. Patents 6,309,792 (Hauck et al.), 6.010,824 (Komano et al.), 5,885,746 (Iwai et al), 5,496,903 (Watanabe et al.), and 5,219,709 (Nagasaka et al.).

The azinium form of azine compounds can also be used if desired. In azinium compounds, a quaternizing substituent of a nitrogen atom in the azine ring is capable of being released as a free radical. The alkoxy substituent that quaternizes a ring nitrogen atom of the azinium nucleus can be selected from among a variety of alkoxy substituents.

Halomethyl-substituted triazines, such as trihalomethyl triazines, are particularly useful in the initiator composition. Representative compounds of this type include but are not limited to, 1,3,5-triazine derivatives such as those having 1 to 3 -CX₃ groups wherein X independently represent chlorine or bromine atoms, including polyhalomethyl-substituted triazines and other triazines, such as 2,4-trichloromethyl-6-methoxyphenyl triazine, 2-phenyl-4,6-bis(trichloromethyl)-s-triazine, 2,4,6-tris(trichloromethyl)-s-triazine, 2-methyl-4,6-bis(trichloromethyl)-s-triazine, 2-(styryl-4,6-bis(trichloromethyl)-s-triazine, 2-(*p-*methoxystyryl)-4,6-bis(trichloromethyl)-s-triazine, 2-(4-methoxy-naphtho-1-yl)-4,6-bis(trichloromethyl)-s-triazine, 2-(4-ethoxynaphtho-1yl)-4,6-bis(trichloromethyl)-s-triazine, and 2-(4-(2-ethoxyethyl)-naphtho-1-yl)-4,6-bis(trichloromethyl)-s-triazine], 2-(4-methylthiophenyl)-4,6-bis(trichloromethyl)-2-triazine, 2-(4-chlorophenyl-4,6-bis(trichloromethyl)-2-triazine, 2,4,6-tri(trichloromethyl)-2-triazine, and 2,4,6-tri(tribromomethyl)-2-triazine.

The azine compounds and particularly the triazine compounds may be used alone or in combination with one or more co-initiators such as titanocenes, mono- and polycarboxylic acids, hexaarylbisimidazoles, as described for example in Patent 4,997,745 (Kawamura et al.).

In some embodiments, the radiation-sensitive composition also includes a mercaptan derivative such as a mercaptotriazole such as 3-mercapto-1,2,4-triazole, 4-methyl-3-mercapto-1,2,4-triazole, 5-mercapto-1-phenyl-1,2,4-triazole, 4-amino-3-mercapto-1,2,4,-triazole, 3-mercapto-1,5-diphenyl-1,2,4-triazole, and 5-(*p*-aminophenyl)-3-mercapto-1,2,4-triazole. Various mercaptobenzimidazoles, mercaptobenzothiazoles, and mercaptobenzoxazoles may also be present.

Thus, several initiator/co-initiator combinations can be used in various embodiments of the present invention, namely:
a) a triazine as described above in combination with a co-initiator that is an N-aryl, S-aryl, or O-aryl polycarboxylic acids with at least 2 carboxy groups of which at least one is bonded to the nitrogen, oxygen, or sulfur atom of the aryl moiety (such as aniline diacetic acid and derivatives thereof) as described above,
b) a triazine as described above in combination with a co-initiator that is a mercaptan derivative as described above,
c) an iodonium salt (such as an iodonium borate) as described above in combination with a co-initiator that is a metallocene (for example a titanocene or ferrocene) as described for example in U.S. Patent 6,936,384 (noted above), and
d) an iodonium salt (such as an iodonium borate) as described above in combination with a co-initiator that is a mercaptotriazole as described above.

The free radical generating compounds in the initiator composition are generally present in the radiation-sensitive composition in an amount of at least 0.5% and up to and including 30%, and preferably at least 1 and up to and including 15%, based on composition total solids or total dry weight of the imageable layer. The optimum amount of the various sensitizers may differ for various compounds and the sensitivity of the radiation-sensitive composition that is desired and would be readily apparent to one skilled in the art. For example, a triazine may be present in an imageable element at a dry coverage of at least 10 mg/m².

The imageable layer of the imageable elements of the present invention comprises a polymeric binder comprising a polymer backbone to which are directly or indirectly linked poly(alkylene glycol) side chains; when the element is exposed to imaging radiation having a λₘₐₓ of at least 250 nm and up to and including 450 nm the binder further comprises pendant carboxy groups.

Any of a variety of polymeric binders can be used in the radiation-sensitive composition, including those known in the art for use in negative-working radiation-sensitive compositions. The polymeric binders generally have a molecular weight of at least 2,000 and up to and including 1,000,000, preferably at least 10,000 and up to and including 200,000, and most preferably at least 10,000 and up to and including 100,000. The acid value (mg KOH/g) of the polymeric binder is generally from 0 and up to and including 400, preferably at least 10 and up to and including 200, and most preferably at least 10 and up to and including 130, as determined using known methods. However, the predominant polymeric binders (at least 60 weight % of total dry polymeric binders) in the radiation-sensitive composition (and imageable elements described below) are those having poly(alkylene glycol) side chains directly or indirectly linked to the polymeric backbone. Preferably, at least 5 weight % and up to and including 100 weight % of the total polymeric binders are composed of one or more of such polymeric binders.

Many of such polymeric binders are dispersible, developable, or soluble in water or water/solvent mixtures such as fountain solutions or mixtures of fountain solutions and lithographic printing inks. Such polymeric binders include polymeric emulsions, dispersions, or polymers having the pendant poly(alkylene glycol) side chains that can render the imageable elements as "on-press" developable. Such polymeric binders are described for example in U.S. Patents 6,582,882 and 6,899,994 (both noted above). In some instances, these polymeric binders are present in the imageable layer at least partially, but preferably entirely, as discrete particles.

Other useful polymeric binders have hydrophobic backbones and comprise both of the following a) and b) recurring units, or the b) recurring units alone:
a) recurring units having pendant cyano groups attached directly to the hydrophobic backbone, and
b) recurring units having pendant groups comprising poly(alkylene glycol) side chains.

These polymeric binders comprise poly(alkylene glycol) side chains. These polymers can be graft copolymers having a main chain polymer and poly(alkylene glycol) pendant side chains. Other polymers are block copolymers having blocks or segments of (alkylene glycol)-containing recurring units and non(alkylene glycol)-containing recurring units. Both graft and block copolymers can additionally have pendant cyano groups attached directly to the hydrophobic backbone. The alkylene glycol side chains generally comprise at least 10 constitutional alkylene glycol units and up to and including 150 of such units, preferably at least 10 and up to and including 100 of such units, more preferably at least 10 and up to and including 50 of such alkylene glycol units, and most preferably at least 15 and up to and including 50 of such alkylene glycol units. The constitutional alkylene glycol units can be the same or different in an individual side chain and are generally C₁ to C₆ alkylene glycol groups, and more typically C₁ to C₃ alkylene glycol groups. The alkylene portions can be linear or branched or substituted versions thereof. Poly(ethylene glycol) and poly(propylene glycol) side chains are preferred and poly(ethylene glycol) side chains are most preferred.

As noted above, in some embodiments, the polymeric binders comprise recurring units comprising the poly(alkylene glycol) side chains as well as recurring units having pendant cyano groups attached directly to the hydrophobic backbone. By way of example only, such recurring units can comprise pendant groups comprising -CN, cyano-substituted or cyano-terminated alkylene groups. Recurring units can also be derived from ethylenically unsaturated polymerizable monomers such as acrylonitrile, methacrylonitrile, methyl cyanoacrylate, ethyl cyanoacrylate, or a combination thereof. However, cyano groups can be introduced into the polymer by other conventional means. Examples of such cyano-containing polymeric binders are described for example in U.S. Patent Application Publication 2005/003285 (Hayashi et al.).

By way of example, polymeric binders that are particularly useful in the IR-sensitive compositions and imageable elements can be formed by polymerization of a combination or mixture of suitable ethylenically unsaturated polymerizable monomers or macromers, such as:
A) acrylonitrile, methacrylonitrile, or a combination thereof,
B) poly(alkylene glycol) esters of acrylic acid or methacrylic acid, such as poly(ethylene glycol) methyl ether acrylate, poly(ethylene glycol) methyl ester methacrylate, or a combination thereof, and
C) optionally, monomers such as acrylic acid, methacrylic acid, styrene, hydroxystyrene, acrylate esters, vinyl carbazole, methacrylate esters, acrylamide, N-phenyl maleimide, carboxyphenyl methacrylamide, allyl methacrylate, carboxyphenyl maleimide, 2-acrylamido-2-methyl-1-propane sulfonic acid, methacrylamide, or a combination of such monomers.

In other embodiments of the invention that are sensitized to be imaged with exposing radiation at a wavelength of at least 250 nm and up to and including 450 nm, the polymeric binders further comprise pendant carboxy groups attached directly or indirectly to the polymer backbone. Such pendant carboxy groups are generally provided by incorporating carboxy-containing recurring units into the polymeric binder chain.

The amount of the poly(alkylene glycol) side chains in such polymeric binders is at least 0.5 and up to and including 60 weight %, preferably at least 2 and up to and including 50 weight %, more preferably at least 5 and up to and including 40 weight %, and most preferably at least 5 and up to and including 20 weight %, based on the total polymeric binder weight. The amount of poly(alkylene glycol) segments in block copolymers is generally at least 5 and up to and including 60 weight %, preferably at least 10 and up to and including 50 weight %, and more preferably at least 10 and up to and including 30 weight %. It is also preferred for some embodiments that the polymeric binders having poly(alkylene glycol) side chains are present at least partially in the form of discrete particles.

Where the polymeric binders comprise pendant cyano groups, the amount of such cyano groups is at least 5 and up to and including 99.5 weight %, preferably at least 10 and up to and including 80 weight %, and most preferably at least 25 and up to and including 60 weight %, based on the total polymeric binder weight.

The polymeric binders comprising (alkylene glycol) side chains are generally present in an amount of at least 10 and up to and including 90%, and preferably at least 20 and up to and including 80%, based on the total solids content of the radiation-sensitive composition or the dry weight of the imageable layer prepared therefrom.

In some embodiments, it may be useful to include "secondary" polymeric binder in combination with the polymeric binders described above. Such secondary polymeric binders include acrylic-urethane hybrid polymers that are commercially available in dispersions from Air Products and Chemicals, Inc. (Allentown, PA) under the tradename Hybridur, for example, the Hybridur 540, 560, 570, 580, 870, and 878 acrylic-urethane hybrid dispersions. Other secondary polymeric binders are water-insoluble but soluble in conventional alkaline developers. Examples of such polymeric binders include but are not limited to, (meth)acrylic acid and acid ester resins [such as (meth)acrylates], polyvinyl acetals, phenolic resin, polymers derived from styrene, N-substituted cyclic imides or maleic anhydrides, such as those described in EP 1,182,033 (noted above) and U.S. Patents 6,309,792 (noted above), 6,352,812 (Shimazu et al.), 6,569,603 (noted above), and 6,893,797 (noted above). Also useful are the vinyl carbazole polymers described in copending and commonly assigned U.S.S.N. 11/356,518 (filed February 17, 2006 by Tao et al.) and the polymers having pendant vinyl groups as described in copending and commonly assigned 11/349,376 (filed February 7,2006 by Tao et al.). The secondary polymeric binder may be present in the radiation-sensitive composition in an amount of from 5 to 40 weight % based on the total solids content of the composition, or the dry coated weight of the imageable layer.

The radiation-sensitive composition generally includes one or more radiation absorbing compounds, or sensitizers, that absorb imaging radiation, or sensitize the composition to imaging radiation having a λₘₐₓ of from the UV to the IR region of the electromagnetic spectrum, that is, at least 150 nm and up to and including 1500 nm. Some sensitizers can be used at any wavelength, but most sensitizers are optimally useful within certain wavelength ranges. For example, some sensitizers are optimal for use at an exposing wavelength of at least 250 nm and up to and including 650 nm (UV to visible). Other sensitizers are particularly optimal for use for exposure to UV radiation of at least 250 nm and up to and including 450 nm, while still others are optimal for use at an exposure wavelength of at least 650 nm and up to and including 1500 nm (near IR and IR).

In some preferred embodiments, the radiation-sensitive composition contains a UV sensitizer where the free-radical generating compound is UV radiation sensitive (that is at least 250 nm and up to and including 450 nm), thereby facilitating photopolymerization. Typical UV radiation-sensitive free-radical generating compounds are described above. In some preferred embodiments, the radiation sensitive compositions are sensitized to "violet" radiation in the range of at least 375 nm and up to and including 450 nm. Useful sensitizers for such compositions include certain pyrilium and thiopyrilium dyes and 3-ketocoumarins (particularly in combination with a polycarboxylic acid free radical generating compound, such as anilino-N,N-diacetic acid).

Sensitizers that absorb in the visible region of the electromagnetic spectrum (that is at least 400 nm and up to and including 650 nm) can also be used. Examples of such sensitizers are well known in the art and include the compounds described in Cols. 17-22 of U.S. Patent 6,569,603 (noted above). Other useful visible and UV-sensitive sensitizing compositions include a cyanine dye, diaryliodonium salt, and a co-initiator (as described above) as described in U.S. Patent 5,368,990 (Kawabata et al.).

Other useful sensitizers for the violet/visible region of sensitization are the 2,4,5-triaryloxazole derivatives as described in WO 2004/074930 (Baumann et al.). These compounds can be used alone or with a co-initiator as described above, and especially with the 1,3,5-triazines described above or with thiol compounds. Useful 2,4,5-triaryloxazole derivatives can be represented by the Structure G-(Ar₁)₃ wherein Ar₁ is the same or different, substituted or unsubstituted carbocyclic aryl group having 6 to 12 carbon atoms in the ring, and G is a furan, oxazole, or oxadiazole ring. The Ar₁ groups can be substituted with one or more halo, substituted or unsubstituted alkyl, substituted or unsubstituted cycloalkyl, substituted or unsubstituted aryl, amino (primary, secondary, or tertiary), or substituted or unsubstituted alkoxy or aryloxy groups. Thus, the aryl groups can be substituted with one or more R'₁ through R'₃ groups, respectively, that are independently hydrogen or a substituted or unsubstituted alkyl group having from 1 to 20 carbon atoms (such as methyl, ethyl, *iso*-propyl, *n*-hexyl, benzyl, and methoxymethyl groups) substituted or unsubstituted carbocyclic aryl group having 6 to 10 carbon atoms in the ring (such as phenyl, naphthyl, 4-methoxyphenyl, and 3-methylphenyl groups), substituted or unsubstituted cycloalkyl group having 5 to 10 carbon atoms in the ring, a -N(R'₄)(R'₅) group, or a -OR'₆ group wherein R'₄ through R'₆ independently represent substituted or unsubstituted alkyl or aryl groups as defined above. Preferably, at least one of R'₁ through R'₃ is an -N(R'₄)(R'₅) group wherein R'₄ and R'₅ are the same or different alkyl groups. Preferred substituents for each Ar₁ group include the same or different primary, secondary, and tertiary amines and more preferably they are the same dialkylamines.

Still another class of useful violet/visible radiation sensitizers includes compounds represented by the Structure Ar₁-G-Ar₂ wherein Ar₁ and Ar₂ are the same or different substituted or unsubstituted aryl groups having 6 to 12 carbon atoms in the ring, or Ar₂ can be an arylene-G-Ar₁ or arylene-G-Ar₂ group, and G is a furan, ozazole, or oxadiazole ring. Ar₁ is the same as defined above, and Ar₂ can be the same or different aryl group as Ar₁. "Arylene" can be any of the aryl groups defined for Ar₁ but with a hydrogen atom removed to render them divalent in nature.

Additional useful "violet"-visible radiation sensitizers are the compounds described in WO 2004/074929 (Baumann et al.). These compounds comprise the same or different aromatic heterocyclic groups connected with a spacer moiety that comprises at least one carbon-carbon double bond that is conjugated to the aromatic heterocyclic groups, and are represented in more detail by Formula (I) of the noted publication.

In embodiments of this invention that are sensitive to infrared radiation, the radiation-sensitive compositions can further comprise an infrared radiation absorbing compound ("IR absorbing compounds") that absorbs radiation of at least 700 nm and up to and including 1500 nm and preferably of at least 750 nm and up to and including 1200 nm. For imageable elements designed for on-press development, it is particularly useful for such IR absorbing compounds to be used in combination with onium salts to enhance polymerization of the polymerizable component and to produce a more durable printing plate.

Useful IR-sensitive radiation absorbing compounds include carbon blacks and other IR-absorbing pigments and various IR-sensitive dyes ("IR dyes"). Examples of suitable IR dyes include but are not limited to, azo dyes, squarilium dyes, croconate dyes, triarylamine dyes, thioazolium dyes, indolium dyes, oxonol dyes, oxaxolium dyes, cyanine dyes, merocyanine dyes, phthalocyanine dyes, indocyanine dyes, indotricarbocyanine dyes, oxatricarbocyanine dyes, thiocyanine dyes, thiatricarbocyanine dyes, merocyanine dyes, cryptocyanine dyes, naphthalocyanine dyes, polyaniline dyes, polypyrrole dyes, polythiophene dyes, chalcogenopyryloarylidene and bi(chalcogenopyrylo) polymethine dyes, oxyindolizine dyes, pyrylium dyes, pyrazoline azo dyes, oxazine dyes, naphthoquinone dyes, anthraquinone dyes, quinoneimine dyes, methine dyes, arylmethine dyes, squarine dyes, oxazole dyes, croconine dyes, porphyrin dyes, and any substituted or ionic form of the preceding dye classes. Suitable dyes are also described in U.S. Patent 5,208,135 (Patel et al.). Cyanine dyes may also be useful in combination with a trihalomethyl triazine and an organoboron salt as described for example in U.S. Patent 5,496,903 (Watanabe et al.).

A general description of one class of suitable cyanine dyes is shown by the formula in paragraph [0026] of WO 2004/101280 (Munnelly et al.), cited herein, and two specific examples of useful IR absorbing compounds are identified below with the Examples as IR Dyes 1 and 2.

In addition to low molecular weight IR-absorbing dyes, IR dye moieties bonded to polymers can be used as well. Moreover, IR dye cations can be used as well, that is, the cation is the IR absorbing portion of the dye salt that ionically interacts with a polymer comprising carboxy, sulfo, phospho, or phosphono groups in the side chains.

Near infrared absorbing cyanine dyes are also useful and are described for example in U.S. Patents 6,309,792 (Hauck et al.), 6,264,920 (Achilefu et al.), 6,153,356 (Urano et al.), 5,496,903 (Watanate et al.). Suitable dyes may be formed using conventional methods and starting materials or obtained from various commercial sources including American Dye Source (Baie D'Urfe, Quebec, Canada) and FEW Chemicals (Germany). Other useful dyes for near infrared diode laser beams are described, for example, in U.S Patent 4,973,572 (DeBoer).

Useful IR absorbing compounds include carbon blacks including carbon blacks that are surface-functionalized with solubilizing groups are well known in the art. Carbon blacks that are grafted to hydrophilic, nonionic polymers, such as FX-GE-003 (manufactured by Nippon Shokubai), or which are surface-functionalized with anionic groups, such as CAB-O-JET^{®} 200 or CAB-O-JET^{®} 300 (manufactured by the Cabot Corporation) are also useful.

The radiation absorbing compound (or sensitizer) can be present in the radiation-sensitive composition in an amount generally of at least 0.1 % and up to and including 30% and preferably at least 2 and up to and including 15%, based on total solids in the composition, that also corresponds to the total dry weight of the imageable layer. Alternatively, the amount can be defined by an absorbance in the range of at least 0.05 and up to and including 3, and preferably at least 0.1 and up to and including 1.5, in the dry film as measured by reflectance UV-visible spectrophotometry. The particular amount needed for this purpose would be readily apparent to one skilled in the art, depending upon the specific compound used.

The radiation-sensitive composition further comprises one or more nonionic phosphate acrylates, each of which has a molecular weight generally greater than 250 and preferably at least 300 and up to and including 1000.

said nonionic phosphate acrylates are nonionic phosphate di- or triacrylates that are present in the imageable layer in an amount of at least 8 and up to and including 300 mg/m². By "nonionic" we mean that the phosphate acrylates not only are neutral in charge but they have no internal positive or negative charges. Thus, they are not internal salts or salts formed with an external cation or anion. Moreover, by "phosphate acrylate" we also meant to include "phosphate methacrylates" and other derivatives having substituents on the vinyl group in the acrylate moiety.

It is also preferred that each phosphate moiety is connected to an acrylate moiety by an alkyleneoxy chain, that is a -(alkylene-O)ₘ- chain composed of at least one alkyleneoxy unit, in which the alkylene moiety has 2 to 6 carbon atoms and can be either linear or branched and m is 1 to 10. Preferably, the alkyleneoxy chain comprises ethyleneoxy units, and m is from 2 to 8 and more preferably, m is from 3 to 6. The alkyleneoxy chains in a specific compound can be the same or different in length and have the same or different alkylene group.

More particularly, the nonionic phosphate acrylates useful in this invention can be represented by the following Structure (I):

P(=O)(OH)ₙ(R)₃₋ₙ (I)

wherein the R groups are independently the same or different groups represented by the following Structure (II): 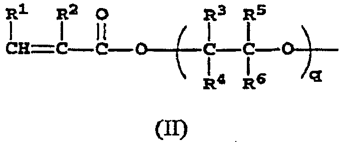 wherein R¹ and R² are independently hydrogen, or a halo group (such as fluoro, chloro, bromo, or iodo) or a substituted or unsubstituted alkyl group having 1 to 4 carbon atoms (such as methyl, chloromethyl, ethyl, isopropyl, *n*-butyl, and t-butyl). Preferably, R¹ and R² are independently hydrogen, methyl, or chloro, and more preferably, they are independently hydrogen or methyl.

R³ through R⁶ are independently hydrogen or a substituted or unsubstituted alkyl group having 1 to 5 carbon atoms (such as methyl, chloromethyl, hydroxymethyl, ethyl, *iso*-propyl, *n*-butyl, *t*-butyl, and *n*-pentyl). Preferably, R³ through R⁶ are independently hydrogen or substituted or unsubstituted methyl or ethyl groups, and more preferably, they are independently hydrogen or unsubstituted methyl groups.

Also, in Structure I, n is 1.

In Structure II, q is 1 to 10, preferably, 2 to 8, and more preferably 3 to 6.

Representative nonionic phosphate acrylates useful in this invention include but are not limited to,
a phosphate of 2-hydroxyethyl methacrylate that is available as Kayamer PM-2 from Nippon Kayaku (Japan) that is shown below, a phosphate of caprolactone modified 2-hydroxyethyl methacrylate that is available as Kayamer PM-21 (Nippon Kayaku, Japan) that is also shown below.

Other useful nonionic phosphate acrylates are also shown below.

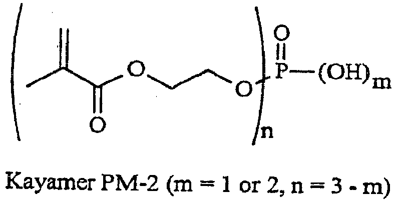

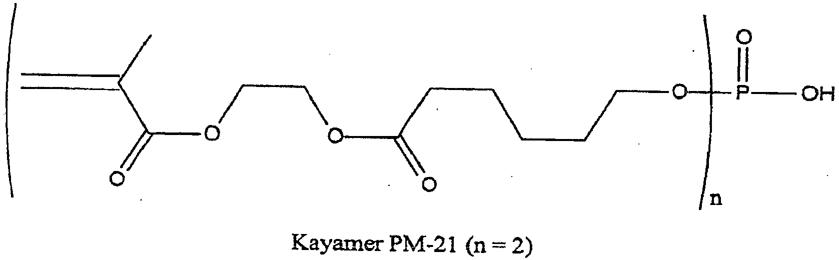

The nonionic phosphate acrylate is present in the radiation-sensitive composition in an amount of at least 0.6 and up to and including 20% and preferably at least 0.9 and up to and including 10%, by weight of the total solids. In the dry imageable layers of the imageable elements, the amount of nonionic phosphate acrylate is present in an amount of at least 8 mg/m² and up to and including 300 mg/m² and preferably at least 10 and up to and including 150 mg/m².

The nonionic phosphate acrylates useful in this invention can be prepared using known reaction conditions and starting materials and several of them are available from commercial sources.

The radiation-sensitive composition can also include a "primary additive" that is a poly(alkylene glycol) or an ether or ester thereof that has a molecular weight of at least 200 and up to and including 4000 (preferably at least 500 and up to and including 2000). This primary additive is present in an amount of at least 2 and up to and including 50 weight % (preferably at least 5 and up to and including 30%) based on the total solids content of the composition, or the total dry weight of the imageable layer.

Particularly useful primary additives include, but are not limited to, one or more of polyethylene glycol, polypropylene glycol, polyethylene glycol methyl ether, polyethylene glycol dimethyl ether, polyethylene glycol monoethyl ether, polyethylene glycol diacrylate, ethoxylated bisphenol A di(meth)acrylate, and polyethylene glycol mono methacrylate. Also useful are SR9036 (ethoxylated (30) bisphenol A dimethacrylate), CD9038 (ethoxylated (30) bisphenol A diacrylate), and SR494 (ethoxylated (5) pentaerythritol tetraacrylate), and similar compounds all of which that can be obtained from Sartomer Company, Inc. In some embodiments, the primary additive may be "nonreactive" meaning that it does not contain polymerizable vinyl groups.

The radiation-sensitive composition can also include a "secondary additive" that is a poly(vinyl alcohol), a poly(vinyl pyrrolidone), poly(vinyl imidazole), or polyester in an amount of up to and including 20 weight % based on the total solids content of the composition, or the total dry weight of the imageable layer.

The radiation-sensitive composition can also include a variety of optional compounds including but not limited to, dispersing agents, humectants, biocides, plasticizers, surfactants for coatability or other properties, viscosity builders, dyes or colorants to allow visualization of the written image, pH adjusters, drying agents, defoamers, preservatives, antioxidants, development aids, rheology modifiers or combinations thereof, or any other addenda commonly used in the lithographic art, in conventional amounts. Useful viscosity builders include hydroxypropyl cellulose, hydroxyethyl cellulose, carboxymethyl cellulose, and poly(vinyl pyrrolidones).

### Imageable Elements

The imageable elements are formed by suitable application of a radiation-sensitive composition as described above to a suitable substrate to form an imageable layer. This substrate can be treated or coated in various ways as described below prior to application of the radiation-sensitive composition. Preferably, there is only a single imageable layer comprising the radiation-sensitive composition of this invention. If the substrate has been treated to provide an "interlayer" for improved adhesion or hydrophilicity, the applied radiation-sensitive composition is generally considered the "top" or outermost layer. These interlayers, however, are not considered "imageable layers". While there is usually no need to apply what is conventionally known as an overcoat (such as an oxygen impermeable topcoat) to the imageable layer(s) as described in WO 99/06890 (Pappas et al.), it can be disposed thereon if desired, particular for imageable elements designed for imaging exposure in the range of from 250 to 450 nm. Such overcoat layers can comprise one or more water-soluble polymers such as poly(vinyl alcohol), poly(vinyl pyrrolidone), poly(ethyleneimine), and poly(vinyl imidazole) and generally have a dry coating weight of at least 0.1 and up to and including 4 g/m².

The substrate generally has a hydrophilic surface, or at least a surface that is more hydrophilic than the applied radiation-sensitive composition on the imaging side. The substrate comprises a support that can be composed of any material that is conventionally used to prepare imageable elements such as lithographic printing plates. It is usually in the form of a sheet, film, or foil, and is strong, stable, and flexible and resistant to dimensional change under conditions of use so that color records will register a full-color image. Typically, the support can be any self-supporting material including polymeric films (such as polyester, polyethylene, polycarbonate, cellulose ester polymer, and polystyrene films), glass, ceramics, metal sheets or foils, or stiff papers (including resin-coated and metallized papers), or a lamination of any of these materials (such as a lamination of an aluminum foil onto a polyester film). Metal supports include sheets or foils of aluminum, copper, zinc, titanium, and alloys thereof, and aluminum supports are most preferred.

Polymeric film supports may be modified on one or both flat surfaces with a "subbing" layer to enhance hydrophilicity, or paper supports may be similarly coated to enhance planarity. Examples of subbing layer materials include but are not limited to, alkoxysilanes, amino-propyltriethoxysilanes, glycidioxypropyl-triethoxysilanes, and epoxy functional polymers, as well as conventional hydrophilic subbing materials used in silver halide photographic films (such as gelatin and other naturally occurring and synthetic hydrophilic colloids and vinyl polymers including vinylidene chloride copolymers).

A preferred substrate is composed of an aluminum support that may be treated using techniques known in the art, including roughening of some type by physical (mechanical) graining, electrochemical graining, or chemical graining, then usually followed by acid anodizing. More preferably, the aluminum support is roughened by physical or electrochemical graining and then anodized using phosphoric or sulfuric acid and conventional procedures. A most preferred substrate is an electrochemically grained and sulfuric acid anodized aluminum support.

An interlayer may be formed by treatment of the aluminum support with, for example, a silicate, dextrine, calcium zirconium fluoride, hexafluorosilicic acid, poly(vinyl phosphonic acid) (PVPA), vinyl phosphonic acid copolymer, poly(acrylic acid), or acrylic acid copolymer. Still further, the aluminum support may be treated with a phosphate solution that may further contain an inorganic fluoride (PF). Preferably, the aluminum support is electrochemically-grained, sulfuric acid-anodized, and treated with PVPA or PF using known procedures to improve surface hydrophilicity.

The thickness of the substrate can be varied but should be sufficient to sustain the wear from printing and thin enough to wrap around a printing form. Preferred embodiments include a treated aluminum foil having a thickness of at least 100 µm and up to and including 600 µm.

The backside (non-imaging side) of the substrate may be coated with antistatic agents and/or slipping layers or a matte layer to improve handling and "feel" of the imageable element.

The substrate can also be a cylindrical surface having the radiation-sensitive composition applied thereon, and thus be an integral part of the printing press. The use of such imaging cylinders is described for example in U.S. Patent 5,713,287 (Gelbart).

The radiation-sensitive composition can be applied to the substrate as a solution or dispersion in a coating liquid using any suitable equipment and procedure, such as spin coating, knife coating, gravure coating, die coating, slot coating, bar coating, wire rod coating, roller coating, or extrusion hopper coating. The composition can also be applied by spraying onto a suitable support (such as an on-press printing cylinder). Preferably, the radiation-sensitive composition is applied as the outermost layer.

Illustrative of such manufacturing methods is mixing the radically polymerizable component, initiator composition, radiation absorbing compound, polymeric binder, primary additive, and any other components of the radiation-sensitive composition in a suitable organic solvent [such as methyl ethyl ketone (2-butanone), methanol, ethanol, 1-methoxy-2-propanol, *iso*-propyl alcohol, acetone, γ-butyrolactone, *n*-propanol, tetrahydrofuran, and others readily known in the art, as well as mixtures thereof], applying the resulting solution to a substrate, and removing the solvent(s) by evaporation under suitable drying conditions. Preferred coating solvents and representative imageable layer formulations are described in the Examples below. After proper drying, the coating weight of the imageable layer is generally at least 0.1 and up to and including 5 g/m², preferably at least 0.5 and up to and including 3.5 g/m², and more preferably at least 0.5 and up to and including 2 g/m².

Layers can also be present under the imageable layer to enhance developability or to act as a thermal insulating layer. The underlying layer should be soluble or at least dispersible in the developer and preferably have a relatively low thermal conductivity coefficient.

The various layers may be applied by conventional extrusion coating methods from melt mixtures of the respective layer compositions. Typically such melt mixtures contain no volatile organic solvents.

Intermediate drying steps may be used between applications of the various layer formulations to remove solvent(s) before coating other formulations. Drying steps at conventional times and temperatures may also help in preventing the mixing of the various layers.

### Imaging Conditions

During use, the imageable element is exposed to a suitable source of imaging or exposing radiation such as UV, visible light, near-infrared, or infrared radiation, depending upon the radiation absorbing compound present in the radiation-sensitive composition, at a wavelength of from 150 to 1500 nm. In some embodiments, imaging is carried out using a source of UV or "violet" imaging or exposing radiation at from at least 250 nm and up to and including 450 nm and preferably at least 375 nm and up to and including 450 nm. Preferably, imaging is carried out using imaging or exposing radiation, such as from an infrared laser at a wavelength of at least 700 nm and up to and including 1400 nm and preferably at least 700 nm and up to and including 1200 nm. Imaging can be carried out using imaging radiation at multiple wavelengths at the same time if desired.

The laser used to expose the imageable element is preferably a diode laser, because of the reliability and low maintenance of diode laser systems, but other lasers such as gas or solid-state lasers may also be used. The combination of power, intensity and exposure time for laser imaging would be readily apparent to one skilled in the art. Presently, high performance lasers or laser diodes used in commercially available imagesetters emit infrared radiation at a wavelength of at least 800 nm and up to and including 850 nm or at least 1060 and up to and including 1120 nm.

The imaging apparatus can function solely as a platesetter or it can be incorporated directly into a lithographic printing press. In the latter case, printing may commence immediately after imaging and development, thereby reducing press set-up time considerably. The imaging apparatus can be configured as a flatbed recorder or as a drum recorder, with the imageable member mounted to the interior or exterior cylindrical surface of the drum. An example of an useful imaging apparatus is available as models of Creo Trendsetter^{®} platesetters available from Eastman Kodak Company (Burnaby, British Columbia, Canada) that contain laser diodes that emit near infrared radiation at a wavelength of 830 nm. Other suitable imaging sources include the Crescent 42T Platesetter that operates at a wavelength of 1064 nm (available from Gerber Scientific, Chicago, IL) and the Screen PlateRite 4300 series or 8600 series platesetter (available from Screen, Chicago, IL). Additional useful sources of radiation include direct imaging presses that can be used to image an element while it is attached to the printing plate cylinder. An example of a suitable direct imaging printing press includes the Heidelberg SM74-DI press (available from Heidelberg, Dayton, OH).

Imaging with infrared radiation can be carried out generally at imaging energies of at least 30 mJ/cm² and up to and including 500 mJ/cm², preferably at least 50 and up to and including 300 mJ/cm² depending upon the sensitivity of the imageable layer.

Imaging radiation in the UV to visible region of the spectrum, and particularly the UV region (for example at least 250 nm and up to and including 450 nm), can be carried out generally using energies of at least 0.01 mJ/cm² and up to and including 0.5 mJ/cm², and preferably at least 0.02 and up to and including 0.1 mJ/cm². It would be desirable, for example, to image the UV/visible radiation-sensitive imageable elements at a power density in the range of at least 0.5 and up to and including 50 kW/cm² and preferably of at least 5 and up to and including 30 kW/cm². Such imaging could be carried out on-press, or the subsequent development could be carried out on-press.

While laser imaging is preferred in the practice of this invention, imaging can be provided by any other means that provides thermal energy in an imagewise fashion. For example, imaging can be accomplished using a thermoresistive head (thermal printing head) in what is known as "thermal printing", described for example in U.S. Patent 5,488,025 (Martin et al.). Thermal print heads are commercially available (for example, a Fujitsu Thermal Head FTP-040 MCS001 and TDK Thermal Head F415 HH7-1089).

### Development and Printing

Without the need for a pre-heat step after imaging, the imaged elements can be developed "off-press" using conventional processing and a conventional aqueous alkaline or organic solvent-based developer. Alternatively, the imaged elements can be developed, or imaged and developed, "on-press" as described in more detail below.

For off-press development, the developer composition commonly includes surfactants, chelating agents (such as salts of ethylenediaminetetraacetic acid), organic solvents (such as benzyl alcohol), and alkaline components (such as inorganic metasilicates, organic metasilicates, hydroxides, and bicarbonates). The pH of the alkaline developer is preferably at least 8 and up to and including 14. The imaged elements are generally developed using conventional processing conditions. Both aqueous alkaline developers and solvent-based developers can be used with the latter type of developers being preferred.

Aqueous alkaline developers generally have a pH of at least 7 and preferably of at least 11. Useful alkaline aqueous developers include 3000 Developer, 9000 Developer, GOLDSTAR Developer, GREENSTAR Developer, ThermalPro Developer, PROTHERM Developer, MX1813 Developer, Violet 500 Developer, and MX1710 Developer (all available from Kodak Polychrome Graphics, a subsidiary of Eastman Kodak Company). These compositions also generally include surfactants, chelating agents (such as salts of ethylenediaminetetraacetic acid), and alkaline components (such as inorganic metasilicates, organic metasilicates, hydroxides, and bicarbonates).

Organic solvent-based developers are generally single-phase solutions of one or more organic solvents that are miscible with or dispersible in water. Such developers may have neutral, alkaline, or slightly acidic pH. Useful organic solvents include the reaction products of phenol with ethylene oxide and propylene oxide [such as ethylene glycol phenyl ether (phenoxyethanol)], benzyl alcohol, esters of ethylene glycol and of propylene glycol with acids having 6 or less carbon atoms, and ethers of ethylene glycol, diethylene glycol, and of propylene glycol with alkyl groups having 6 or less carbon atoms, such as 2-ethylethanol and 2-butoxyethanol. The organic solvent(s) is generally present in an amount of from 0.5 to 15% based on total developer weight.

Representative solvent-based developers include ND-1 Developer, Developer 980, SP 200 Developer, "2-in-1" Developer, ProNeg D-501 Developer, and 956 Developer (available from Kodak Polychrome Graphics a subsidiary of Eastman Kodak Company).

Generally, the alkaline developer is applied to the imaged element by rubbing or wiping the outer layer with an applicator containing the developer. Alternatively, the imaged element can be brushed with the developer or the developer may be applied by spraying the outer layer with sufficient force to remove the exposed regions. Still again, the imaged element can be immersed in the developer. In all instances, a developed image is produced in a lithographic printing plate having excellent resistance to press room chemicals.

Following off-press development, the imaged element can be rinsed with water and dried in a suitable fashion. The dried element can also be treated with a conventional gumming solution (preferably gum arabic). In addition, a postbake operation can be carried out, with or without a blanket exposure to UV or visible radiation.

Printing can be carried out by applying a lithographic printing ink and fountain solution to the printing surface of the imaged and developed element. The fountain solution is taken up by the non-imaged regions, that is, the surface of the hydrophilic substrate revealed by the imaging and development steps, and the ink is taken up by the imaged (non-removed) regions of the imaged layer. The ink is then transferred to a suitable receiving material (such as cloth, paper, metal, glass, or plastic) to provide a desired impression of the image thereon. If desired, an intermediate "blanket" roller can be used to transfer the ink from the imaged member to the receiving material. The imaged members can be cleaned between impressions, if desired, using conventional cleaning means.

Some imageable elements of this invention are designed for development "on-press". This type of development avoids the use of the developing solutions described above. The imaged element is directed mounted on press wherein the unexposed regions in the imageable layer are removed by a suitable fountain solution, lithographic printing ink, or a combination of both, when the initial printed impressions are made. Typical ingredients of aqueous fountain solutions include pH buffers, desensitizing agents, surfactants and wetting agents, humectants, low boiling solvents, biocides, antifoaming agents, and sequestering agents. A representative example of a fountain solution is Varn Litho Etch 142W + Varn PAR (alcohol sub) (available from Varn International, Addison, IL). On-press development is demonstrated in Example 10 below.

The following examples are provided to illustrate the practice of the invention but are by no means intended to limit the invention in any manner.

### Examples

The components and materials used in the examples and analytical methods used in evaluation were as follows:
BLO represents γ-butyrolactone.

BPE-500 (also HB-NK Ester BPE 500) represents an ethoxylated (10) Bisphenol A dimethacrylate that was obtained from NK-Esters (Japan).

Byk^{®} 307 and 336 surfactants were obtained from Byk Chemie (Wallingford, CT).

Elvacite^{®} 4026 is a highly-branched poly(methyl methacrylate) that was obtained from Ineos Acrylica, Inc. (Cordova, TN).

Graft Copolymer 1 is described in Preparation Example 1 below. It is pre-dissolved to 10% (weight) solids in N,N-dimethylacetamide (DMAC).

Graft Copolymer 2 is described in Preparation Example 2 below.

Graft Copolymer 3 is a 24 weight % dispersion in a 76:24 mixture of *n*-propanol and water and is a copolymer with the composition of PEGMA/acrylonitrile/styrene with a weight ratio of 10/70/20 and was prepared as described in U.S. Patent Application Publication 2005/0003285 (noted above) as Copolymer 7. PEGMA represents poly(ethylene glycol methacrylate) (Mw 2080, Aldrich Chemical Co.).

Graft Copolymer 4 was prepared similarly to Graft copolymer 2 and is a copolymer with the composition of PEGMA/acrylonitrile/vinyl carbazole/methacrylic acid with a weight ratio of 10/50/25/15 and an acid number of 98.

Irgacure^{®} 250 contains iodonium, (4, -methylphenyl)[4-(2-methylpropyl)phenyl]-,hexafluorophosphate that was obtained from Ciba Specialty Chemicals (Tarrytown, NY) as a 75% (weight) solution in propylene carbonate.

IR Dye 1 represents a cyanine dye that has the following structure:

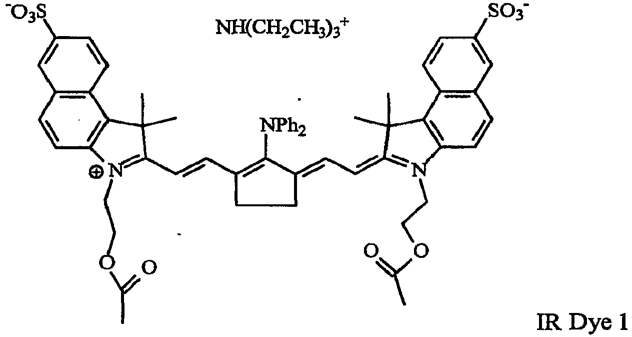

IR Dye 2 is a cyanine dye that was obtained from FEW Chemicals GmbH (Germany) that has the following structure:

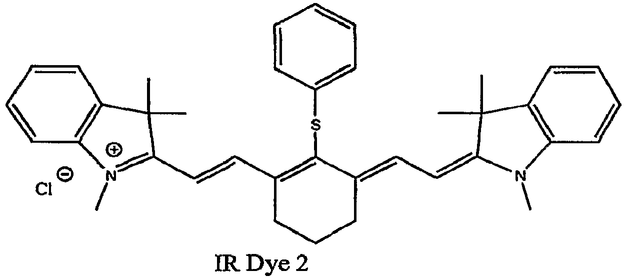

JONCRYL 683 is a styrene/acrylic polymer with an acid number of 150 mg KOH/g that was obtained from S.C. Johnson Polymer (The Netherlands).

Kayamer PM-2 is a phosphate of 2-hydroxyethyl methacrylate and Kayamer PM-21 is a phosphate of caprolactone modified 2-hydroxyethylmethacrylate, both of which were obtained from Nippon Kayaku (Japan).

Klucel^{®} E and Klucel^{®} M are hydroxypropyl celluloses that were obtained from Hercules Inc. (Wilmington, DE).

MEK represents methyl ethyl ketone (or 2-butanone).

Mercapto-3-triazole represents mercapto-3-triazole-1H, 2, 4 that was obtained from PCAS (Paris, France).

N-phenylimino diacetic acid was obtained from Synthon Chemicals GmbH.

Oligomer 1 represents a urethane acrylate that was prepared by reacting 2 parts of hexamethylene diisocyanate with 2 parts of hydroxyethyl methacrylate and 1 part of 2-(2-hydroxyethyl)piperidine (30% (weight) solution in ethyl acetate).

Oligomer 2 represents a urethane acrylate that was prepared by reacting DESMODUR^{®} N100 (an aliphatic polyisocyanate resin based on hexamethylene diisocyanate from Bayer Corp., Milford, CT) with hydroxyethyl acrylate and pentaerythritol triacrylate (80% (weight solution in 2-butanone).

PF represents a post-treatment with an inorganic monosodium phosphate solution activated by sodium fluoride.

PGME represents 1-methoxy-2-propanol that is also known as Dowanol PM.

Pigment 1 represents a 27% solids dispersion of 7.7 parts of a poly(vinyl acetal) derived from poly(vinyl alcohol) acetalized with acetaldehyde, butyraldehyde, and 4-formylbenzoic acid, 76.9 parts of Irgalith Blue GLVO (Cu-phthalocyanaine C.I. Pigment Blue 15:4), and 15.4 parts of Disperbyk^{®} 167 dispersing aid (from Byk Chemie) in 1-methoxy-2-propanol.

PVPA represents poly(vinyl phosphonic acid).

Sartomer 349 is an ethoxylated (3) Bisphenol A diacrylate and Sartomer 399 is a dipentaerythritol pentaacrylate, both of which were obtained from Sartomer Company (Exton, PA).

S 0322 is a barbituric acid-type IR dye that was obtained from FEW Chemicals GmbH (Germany) and has the following structure:

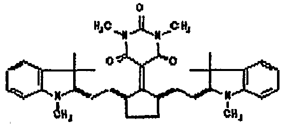

Triazine A represents 2,4-trichloromethyl-6-methoxyphenyl triazine that was obtained from PCAS (Paris, France).

956 Developer is a solvent based (phenoxyethanol) alkaline negative developer (Kodak Polychrome Graphics, a subsidiary of Eastman Kodak Company, Norwalk, CT, USA).

### Preparation Example 1: Graft Copolymer 1:

Dimethylacetamide (225.7 g, DMAC) and poly(ethylene glycol methacrylate) [20 g in 50% water, PEGMA (MW 2080), Aldrich Chemical Co.] were charged to a 500 ml 4-neck ground glass flask, equipped with a heating mantle, temperature controller, mechanical stirrer, condenser, pressure equalized addition funnel, and nitrogen inlet. The reaction mixture was heated to 80°C under nitrogen atmosphere. A pre-mixture of acrylonitrile (60 g), styrene (20 g), methacrylic acid (10 g), and azoisobutrolnitrile (0.5 g, AIBN, Vazo-64 from DuPont) were added over two hours at 80°C. Reaction was continued another eighteen hours and 1.35 g of Vazo-64 was added in increments. The resulting polymer conversion was >98% based on a determination of the percent of non-volatiles. The weight ratio of PEGMA/acrylonitrile/styrene/-methacrylic acid was 10/60/20/10 in DMAC at 30% non-volatiles.

The resin solution was precipitated in powder form using 1700 g of *n*-propanol using a Charles & Ross & Son Company Dispersator (Model # ME 100LC) at 7000 RPM and then the material was filtered. The slurry was redissolved using 550 g of *n*-propanol and the solution was then filtered. The resulting powder was dried at room temperature for 24 hours and 43°C for two days. The yield of Graft Copolymer 1 was 90% and the acid number was 65 mg KOH/g (which is the same as theoretical). Its structure is shown as follows: 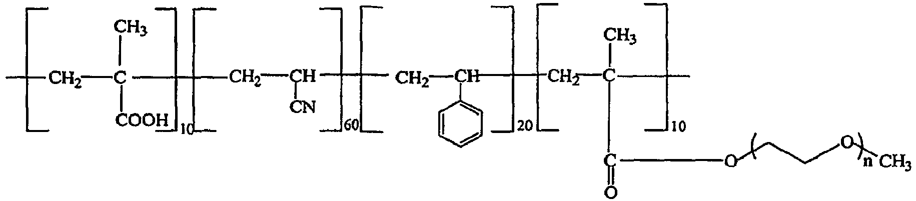 wherein n = 40-50.

### Preparation Example 2: Graft Copolymer 2:

Dimethylacetamide (100.7 g) and PEGMA (20 g in 50% water)) were charged to a 500 ml 4-neck ground glass flask, equipped with a heating mantle, temperature controller, mechanical stirrer, condenser, pressure equalized addition funnel, and nitrogen inlet. The reaction mixture was heated to 80°C under nitrogen atmosphere. A pre-mixture of dimethylacetamide (125 g), vinyl carbazole (25 g), acrylonitrile (35 g), styrene (20 g), methacrylic acid (10 g), and AIBN (0.5 g, Vazo-64) were added over two hours at 80°C. Reaction was continued another fifteen hours and 1.25 g of Vazo-64 were added in increments. Graft Copolymer 2 conversion was >99% based on determination of the percent of non-volatiles. The weight ratio of PEGMA/acrylonitrile/vinyl carbazole/styrene/methacrylic acid was 10/35/25/20/10 in DMAC at 30% non-volatiles.

The resin solution was precipitated in powder form using mixture of 6000 g of water/ice (3:1) using a Lab Dispersator (4000RPM) and then it was filtered. The resulting powder was dried at room temperature for 24 hours and 43°C for two days. The yield was 95% and acid number was 69 mg KOH/g (compared to theoretical of 65). Its structure is shown as follows: 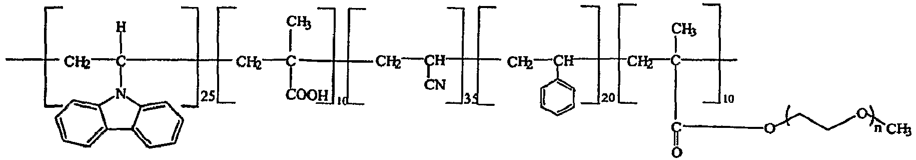 wherein n = 40 - 50.

### Examples 1 and 4-9 & Comparative Examples 1-4: Elements for Off-Press Development

Imageable elements were prepared by coating each of the imageable layer formulations shown in the following TABLE I onto an electrochemically-grained and sulfuric acid-anodized aluminum support that had been post-treated with either PVPA or PF, to provide a dry coating weight of 1.5 g/m². Each imageable layer formulation was applied using a slotted hopper and dried. For the substrates treated with PF, PF#1 had an oxide weight of 2.5 g/m² and PF#2 had an oxide weight of 3.8 g/m².

An overcoat formulation containing 3.19% poly(vinyl alcohol) (88% hydrolyzed), 0.56% poly(vinyl imidazole), 3.85% *iso*-propanol, and 92.4% water was applied to each dried imageable layer to a dry coverage of 1 g/m².

Examples 1 and 4-7 (Ex. 1 and 4-7) represent radiation-sensitive compositions and imageable elements of the present invention while Comparative Examples 1-4 (Comp. 1-4) represent radiation-sensitive compositions and imageable elements outside the scope of the present invention.

**TABLE I**

| **Component** | **Ex. 1** | **Comp. 1** | **Ex. 4** | **Comp. 2** | **Ex. 5** | **Ex. 6** | **Ex. 7** | **Ex. 8** | **Comp. 3** | **Ex. 9** | **Comp. 4** |
|---|---|---|---|---|---|---|---|---|---|---|---|
| Oligomer 1 | 5.16 | 5.16 | 4.17 | 5.30 | 5.23 | 4.85 | 5.20 | 4.39 | 4.17 | 5.16 | 4.39 |
| Sartomer 349 | 1.55 | 1.55 | 1.25 | 1.59 | 1.59 | 1.46 | 0 | 0 | 1.25 | 1.55 | 1.32 |
| BPE-500 | 0 | 0 | 0 | 0 | 0 | 0 | 1.55 | 0 | 0 | 0 | 0 |
| Sartomer 399 | 0 | 0 | 0 | 0 | 0 | 0 | 0 | 1.32 | 0 | 0 | 0 |
| Graft Copolymer 1 | 33.6 | 33.6 | 0 | 33.6 | 33.6 | 33.6 | 0 | 0 | 0 | 0 | 0 |
| Graft Copolymer 2 | 0 | 0 | 2.88 | 0 | 0 | 0 | 0 | 2.88 | 2.88 | 0 | 0 |
| Graft Copolymer 2 (pre-dissolved to 10% wt. in DMAC) | 0 | 0 | 0 | 0 | 0 | 0 | 34.5 | 0 | 0 | 33.6 | 0 |
| JONCRYL 683 | 0 | 0 | 0 | 0 | 0 | 0 | 0 | 0 | 0 | 0 | 2.88 |
| Mercapto-3-triazole | 0.08 | 0.08 | 0.10 | 0.08 | 0.08 | 0.08 | 0.08 | 0.06 | 0.10 | 0.08 | 0.06 |
| Triazine A | 0.24 | 0.24 | 0.26 | 0.24 | 0.24 | 0.24 | 0.38 | 0.21 | 0.26 | 0.24 | 0.21 |
| IR Dye 2 | 0.11 | 0.11 | 0.13 | 0.11 | 0.11 | 0.11 | 0.15 | 0.10 | 0 | 0.11 | 0.10 |
| S 0322 | 0 | 0 | 0 | 0 | 0 | 0 | 0 | 0 | 0.13 | 0 | 0 |
| Pigment 1 | 1.18 | 1.18 | 1.01 | 1.18 | 1.18 | 1.18 | 1.20 | 1.01 | 1.01 | 1.18 | 1.01 |
| N-Phenylimino-diacetic acid | 0.13 | 0.13 | 0.13 | 0.13 | 0.13 | 0.13 | 0.12 | 0.11 | 0.13 | 0.13 | 0.11 |
| Byk^{®} 307 | 0.04 | 0.04 | 0.04 | 0.04 | 0.04 | 0.04 | 0.04 | 0.04 | 0.04 | 0.41 | 0.04 |
| Kayaruer PM-2 | 0.08 | 0 | 0 | 0 | 0.01 | 0.27 | 0.01 | 0.10 | 0.10 | 0.08 | 0.10 |
| Kayamer PM-21 | 0 | 0 | 0.10 | 0 | 0 | 0 | 0 | 0 | 0 | 0 | 0 |
| Ethylene glycol methacrylate phosphate | 0 | 0 | 0 | 0 | 0 | 0 | 0 | 0 | 0 | 0 | 0 |
| Phosmer PE | 0 | 0 | 0 | 0 | 0 | 0 | 0 | 0 | 0 | 0 | 0 |
| Phosmer MH | 0 | 0.08 | 0 | 0 | 0 | 0 | 0 | 0 | 0 | 0 | 0 |
| Acetone | 9.25 | 9.25 | 0 | 9.25 | 9.25 | 9.25 | 9.23 | 0 | 0 | 9.25 | 0 |
| 1-Methoxy-2-propanol | 48.6 | 48.6 | 22.7 | 48.5 | 48.5 | 48.8 | 47.5 | 22.7 | 22.7 | 47.5 | 22.7 |
| BLO | 0 | 0 | 4.68 | 0 | 0 | 0 | 0 | 4.68 | 4.68 | 0 | 4.68 |
| 2-Butanone | 0 | 0 | 57.9 | 0 | 0 | 0 | 0 | 57.8 | 57.9 | 0 | 57.8 |
| Water | 0 | 0 | 4.68 | 0 | 0 | 0 | 0 | 4.68 | 4.68 | 0 | 4.68 |

The resulting imageable elements were imagewise exposed from 25 to 250 mJ/cm² with imaging (exposing) radiation of 830 nm using a Creo Trendsetter^{®} 3244x platesetter (available from Creo, Burnaby, Vancouver, Canada, a subsidiary of Eastman Kodak Company). The imaged elements were then developed with Kodak Negative 956 Developer by hand for 30 seconds. Kodak Finisher 850s was then applied to each printing plate.

The speed of each resulting printing plate was measured as the exposure energy needed to attain 80% of the maximum optical density of a solid image area. A post-development baking step was omitted.

Each imaged and developed printing plate was mounted on a Miehle sheet-fed press charged with black ink containing 1.5% calcium carbonate (wear ink). For some examples, the press was set-up with a compressible blanket. In other examples, the press was set-up with a hard blanket over-packed by 0.001" (0.00254 cm) over aim (specified aim was 0.004", 0.01 cm) in order to increase the rate of plate wear. Press sheet assessments of solid wear and highlight wear were evaluated visually from a press target resolution of 2001pi and 2400dpi. The printing results are shown below in the following TABLES II and III and the speed results are provided in TABLE IV.

**TABLE II (PF#1 Substrate Post-Treatment)**

| **Example** | **Speed** (**mJ**/**cm²**) | **Solid Wear** | **Best Highlight at start (%)** | **Best Highlight at end (%)** | **Comments** |
|---|---|---|---|---|---|
| 1 | 68 | 35,000*, 17,000** | 4 | 10 | |
| Comp. 1 | 53 | n/a | n/a | n/a | Image quality was too poor to perform press testing. |
| 4 | 35 | 9,000** | 2% | 2% | |
| Comp. 2 | 40 | 12,000** | 2% | 6% | Failed the 5th day of 38°C, 80% RH test |
| 5 | 55 | 23,000* | 6 | 45 | |
| 6 | 74 | 13,000** | 4 | 10 | |
| 7 | 35 | 13,000* | 8 | 35 | |
| 8 | 42 | 9,000** | 1% | 2% | Good highlight retention |
| Comp. 3 | 67 | n/a | n/a | n/a | Image quality was too poor to perform press testing |
| 9 | 65 | 17,000** | 2 | 2 | |
| Comp. 4 | 90 | 3,000** | 10 | 20 | |

| | | | | | |
|---|---|---|---|---|---|
| *Wear ink and compressible blanket **Wear ink and hard blanket. | | | | | |

**TABLE III (PF#2 Substrate Post-Treatment)**

| **Example** | **Speed (mJ/cm²)** | **Solid Wear** | **Best Highlight at start (%)** | **Best Highlig ht at end (%)** | **Comments** |
|---|---|---|---|---|---|
| 1 | 64 | 37,000* | 4 | 15 | |
| Comp. 1 | 156 | n/a | N/a | N/a | After development, image quality and resolution were very poor - at 125 mJ/cm², no 50% dots were visible. |
| 4 | 65 | 14,000** | 2% | 6% | |
| Comp. 2 | 46 | 1,000** | 45% | 45% | |
| 5 | 142 | n/a | N/a | N/a | After development, image quality and resolution were very poor - At 125 mJ/cm , no 50% dots were visible. |
| 6 | 69 | 13,000** | 4 | 15 | |
| 7 | 46 | 16,000** | 1% | 2% | |
| Comp. 3 | 90 | 4,000** | 6 | 10 | |

| | | | | | |
|---|---|---|---|---|---|
| *Wear ink and compressible blanket. **Wear ink and hard blanket. | | | | | |

**TABLE IV**

| **Example** | **Post-Treatment** | **Speed (mJ/cm²) at 5 days**/**48°C** | **Speed** (**mJ**/**cm²**) **at 5 days/38*/80% RH** |
|---|---|---|---|
| 1 | PF#1 | 75 | 67 |
| 1 | PF#2 | 90 | 69 |
| Comp. 1 | PF#1 | No images | 120 |
| Comp. 1 | PF#2 | No images | No images |
| 4 | PF#1 | 70 | 103 |
| 4 | PF#2 | 54 | 73 |
| Comp. 2 | PF#1 | 54 (background stain) | 70 (background stain) |
| Comp. 2 | PF#2 | 58 (background stain) | 88 (background stain |
| 5 | PF#1 | 71 | 122 |
| 5 | PF#2 | No images | No images |
| 6 | PF#1 | 92 | 128 |
| 6 | PF#2 | 73 | 127 |
| 7 | PF#1 | 56 | 36 |
| 8 | PF#1 | 102 (background scum) | 119 (background scum) |
| 8 | PF#2 | ∼25 (background scum) | 94 (background scum) |
| Comp. 3 | PF#1 | No images | 41 |
| Comp. 3 | PF#2 | No images | No images |
| 9 | PF#1 | 55 | 79 |
| Comp. 4 | PF#1 | Very weak images | 141 |
| Comp. 4 | PF#2 | Very weak images | 82 |

The speed of the printing plate prepared for Comparative Example 3 was 67 mJ/cm². After an accelerated age test performed for 5 days at 48°C, with the printing plate wrapped in interleaving and foil lined paper, no images resulted for exposures up to 250 mJ/cm². For Example 9, the speed was 65 mJ/cm². After the 5-day treatment at 48°C, as described above, the exposure energy actually dropped to 55 mJ/cm². Barbituric Acid IR dyes appear to be thermally unstable in the elements provided in these examples designed for off-press development.

Improvements in press run length are noted for all examples containing a nonionic phosphate acrylate according to the present invention (see Examples 1, 4-7 and 9). In particular, improvement in highlight dot reproduction and stability during the press run are noted for Example 9. At very low levels of the nonionic phosphate acrylate (∼1.35 mg/m² in the dry film, 0.01 weight % in formulation), such as in Examples 5 and 7, there was a dramatic improvement in plate performance when the PF#1 post-treatment was used. Imageable layers for Example 4 and Comparative Example 2, applied to PF #2 post-treated aluminum substrate, showed image loss after the development step.

After the accelerated aging testing, under either dry (48°C) or humid (38°C, 80% relative humidity) conditions, it was acceptable for speed loss to be in the range of 20 to 60 mJ/cm² with no background staining. Acceptable results were achieved using the PF#2 post-treated imageable layer formulations with a nonionic phosphate acrylate level of 0.08 parts by weight (16.2 mg/m² dry film) or greater. On the PF #1 post-treated substrate, the level of the nonionic phosphate acrylate could be as low as 0.01 parts by weight (1.35 mg/m² dry film) and still provide acceptable results.

### Comparative Example 5:

### Elements for On-Press Development

The imageable layer formulation solution described in TABLE V below was applied to an electrochemically-grained and sulfuric acid anodized aluminum substrate, which had been post-treated with PF#1 to provide a dry coating weight of 1.5 g/m². Each formulation was applied using a slotted-hopper and dried for 60 seconds at 82°C.

**TABLE V**

| **Component** | **Comparative Example 5** |
|---|---|
| Oligomer 2 | 1.24 |
| Sartomer 399 | 0.99 |
| Graft Copolymer 3 | 4.99 |
| Klucel^{®} E | 0 |
| Klucel^{®} M | 0.04 |
| Irgacure^{®} 250 | 0.25 |
| Mercapto-3-triazole | 0.11 |
| IR Dye #1 | 0.16 |
| Byk^{®} 336 | 0.36 |
| Phosmer PE | 0 |
| Elvacite^{®} 4026 | 0.20 |
| 1-Propanol | 64.01 |
| Water | 8.69 |
| 2-Butanone | 18.96 |

The resulting elements were exposed at 300 mJ/cm² with imaging (exposing) radiation of 830 nm on a Creo Trendsetter^{®} 3244x platesetter.

Comparative Example 5 was directly mounted on an ABDick duplicator press charged with Van Son rubber-based black ink. The fountain solution was Varn 142W etch at 3 oz. per gallon (22.5 g/liter) and PAR alcohol replacement at 3 oz. per gallon (22.5 g/liter). An image obtained as 300 mJ/cm² was used to print only about 250 impressions before image failure was observed for both elements having the PVPA and the PF#1 substrate.

### Example 11: "Violet"-Sensitive Imageable Element and Imaging Method

A formulation of 14.2% Colloid 140 (available from Kemira Chemicals, Kennesaw, GA), 4.3% phosphoric acid, and 1.3% Surfactant 10G (available from Arch Chemicals, Norwalk, Connecticut) in water was applied to a brush-grained phosphoric acid-anodized aluminum metal sheet and dried to a final coating weight of 0.03 g/m². A photosensitive formulation was then prepared as detailed in the following TABLE VI and was applied to the described substrate and dried to provide an imageable layer with a film weight of 1.6 g/m².

The imageable layer was then coated with a formulation of 5.64% poly(vinyl alcohol) (88% hydrolyzed), 0.3% poly(vinyl pyrrolidone), 3.76% *iso-*propanol and 90.3% water and dried to provide an overcoat having a film weight of 1.9 g/m². The resulting negative-working imageable element was imaged on a Fuji Luxel Vx-9600 platesetter using imaging (exposing) radiation of 405 nm and an exposure energy of 39 µJ/cm² and processed with Kodak Polychrome Graphics Violet 500 negative plate developer. The resulting printing plate still retained 1% highlight dots after printing 2,000 impressions on a Miehle press.

**TABLE VI**

| **Component** | **Parts by Weight** |
|---|---|
| 10% solution of Graft Copolymer 1 in DMAC | 13.80 |
| HB-NK Ester BPE 500 | 0.46 |
| Oligomer 1 | 8.38 |
| Kayamer PM-2 | 0.06 |
| 2-Phenyl-5-(4-diethylaminophenyl)-4-(2-chlorophenyl)oxazole | 0.85 |
| 2,2'-Bis(2-chlorophenyl)-4,4',5,5'-tetraphenylbiimidazole | 0.21 |
| 3-Mercapto-1,2,4-triazole | 0.38 |
| Pigment 1 | 0.86 |
| Byk^{®} 307 | 0.01 |
| *n*-Propanol | 52.68 |
| 2-Butanone | 20.66 |
| Ethyl acetate | 1.64 |

## Claims

1. A negative-working imageable element comprising a substrate having thereon an imageable layer comprising:
a free radically polymerizable component,
an initiator composition capable of generating free radicals sufficient to initiate polymerization of said free radically polymerizable component upon exposure to imaging radiation,
a radiation absorbing compound,
a polymeric binder comprising a polymer backbone to which are directly or indirectly linked poly(alkylene glycol) side chains, and
a non-ionic phosphate acrylate having a molecular weight of at least 250,
wherein said non-ionic phosphate acrylate is a non-ionic phosphate di- or triacrylate that is present in said imageable layer in an amount of at least 8 and up to and including 300 mg/m²;
provided that when said element is exposed to imaging radiation having a λₘₐₓ of at least 250 nm and up to and including 450 nm, said polymeric binder further comprises pendant carboxy groups.

2. The element of claim 1, wherein said initiator composition comprises a triazine and further comprises a mono- or polycarboxylic acid or mercaptan as a co-initiator.

3. The element of claim 1 wherein said initiator composition comprises an iodonium salt, or an iodonium salt in combination with either a mercaptotriazole or a metallocene, wherein said iodonium salt is optionally an iodonium borate.

4. The element of claim 1, wherein said polymeric binder comprises poly(ethylene glycol) side chains and is present at least partially as discrete particles.

5. The imageable element of claim 1 that is on-press developable and wherein said initiator composition comprises an iodonium salt and a mercaptotriazole.

6. The imageable element of claim 1 that is sensitive to imaging radiation having a wavelength of at least 250 nm and up to and including 450 nm, said radiation absorbing compound is a 2,4,5-triaryloxazole derivative.

7. The imageable element of claim 1, wherein said substrate is a sulfuric acid anodized aluminum-containing substrate.

8. The imageable element of claim 1 further comprising an oxygen impermeable topcoat disposed over said imageable layer.

9. A method of making a negative-working printing plate comprising:
A) imagewise exposing a negative-working imageable element of any of claims 1 to 8 at an imaging radiation to produce exposed and non-exposed regions in each imageable layer, and
B) without a preheat step, developing said imagewise exposed element to remove only said non-exposed regions of said imageable layer.

10. The method of claim 9, wherein step B is carried out on-press in the presence of a fountain solution, printing ink, or a combination thereof.

## Patentansprüche

1. Ein negativ-arbeitendes bebilderbares Element, umfassend ein Substrat mit darauf einer bebilderbaren Schicht, umfassend:
eine radikalisch polymerisierbare Komponente,
eine Initiatorzusammensetzung, die in der Lage ist, freie Radikale zu erzeugen, die ausreichen, um die Polymerisation der radikalisch polymerisierbaren Komponente bei Aussetzung gegenüber bildgebender Strahlung zu initiieren,
eine Strahlung absorbierende Verbindung,
ein polymeres Bindemittel, umfassend ein Polymergerüst, an das direkt oder indirekt Poly(alkylenglycol)-Seitenketten gebunden sind und
ein nicht-ionisches Phosphatacrylat mit einem Molekulargewicht von mindestens 250,
wobei das nicht-ionische Phosphatacrylat ein nicht-ionisches Phosphatdi- oder triacrylat ist, das in der bebilderbaren Schicht in einer Menge von mindestens 8 und bis zu und
einschließlich 300 mg/m² vorliegt;
mit der Maßgabe, dass, wenn das Element bildgebender Strahlung mit einem λₘₐₓ von mindestens 250 nm und bis zu und einschließlich 450 nm ausgesetzt wird, das polymere Bindemittel ferner seitenständige Carboxygruppen umfasst.

2. Das Element gemäß Anspruch 1, wobei die Initiatorzusammensetzung ein Triazin umfasst und ferner eine Mono- öder Polycarbonsäure oder Mercaptan als einen CoInitiator umfasst.

3. Das Element gemäß Anspruch 1, wobei die Initiatorzusammensetzung ein Iodoniumsalz oder ein Iodoniumsalz in Kombination mit entweder einem Mercaptotriazol oder einem Metallocen umfasst, wobei das Iodoniumsalz gegebenfalls ein Iodoniumborat ist.

4. Das Element gemäß Anspruch 1, wobei das polymere Bindemittel Poly(ethylenglycol)-Seitenketten umfasst und zumindest teilweise als diskrete Teilchen vorliegt.

5. Das bebilderbare Element gemäß Anspruch 1, das auf der Presse entwickelbar ist und wobei die Initiatorzusammensetzung ein Iodoniumsalz und ein Mercaptotriazol umfasst.

6. Das bebilderbare Element gemäß Anspruch 1, das empfindlich ist für bildgebende Strahlung mit einer Wellenlänge von mindestens 250 nm und bis zu und einschließlich 450 nm, wobei die Strahlung absorbierende Verbindung ein 2,4,5-Triaryloxazol-Derivat ist.

7. Das bebilderbare Element gemäß Anspruch 1, wobei das Substrat ein mit Schwefelsäure anodisiertes Aluminium-enthaltendes Substrat ist.

8. Das bebilderbare Element gemäß Anspruch 1, ferner umfassend eine sauerstoffundurchlässige Deckschicht, die über der bebilderbaren Schicht angeordnet ist.

9. Ein Verfahren zur Herstellung einer negativ-arbeitenden Druckplatte, umfassend:
A) bildweises Belichten eines negativ-arbeitenden bebilderbaren Elements gemäß einem der Ansprüche 1 bis 8 mit einer bildgebenden Strahlung, um belichtete und nichtbelichtete Bereiche in jeder bebilderbaren Schicht zu erzeugen und
B) ohne einen Schritt des Vorerwärmens, Entwickeln des bildweise belichteten Elements, um nur die nicht-belichteten Bereiche der bebilderbaren Schicht zu entfernen.

10. Das Verfahren gemäß Anspruch 9, wobei Schritt B auf einer Presse in Gegenwart eines Feuchtmittels, Druckfarbe oder einer Kombination davon durchgeführt wird.

## Revendications

1. Elément imageable fonctionnant en négatif comprenant un substrat sur lequel se trouve une couche imageable comprenant :
un composant polymérisable radicalement,
une composition initiatrice capable de générer des radicaux libres suffisants pour initier la polymérisation dudit composant polymérisable radicalement lors d'une exposition à un rayonnement d'imagerie,
un composé d'absorption de rayonnement,
un liant polymère comprenant un squelette polymère auquel des chaînes latérales de poly(alkylène glycol) sont directement ou indirectement liées, et
un acrylate de phosphate non ionique ayant un poids moléculaire d'au moins 250,
dans lequel ledit acrylate de phosphate non ionique est un di- ou triacrylate de phosphate non ionique qui est présent dans ladite couche imageable en une quantité d'au moins 8 et jusqu'à 300 mg/m² inclus ;
à condition que, lorsque ledit élément est exposé à un rayonnement d'imagerie ayant un λₘₐₓ d'au moins 250 nm et jusqu'à 450 nm inclus, ledit liant polymère comprenne en outre des groupes carboxy pendants.

2. Elément selon la revendication 1, dans lequel ladite composition initiatrice comprend une triazine et comprend en outre un acide mono- ou polycarboxylique ou un mercaptane comme co-initiateur.

3. Elément selon la revendication 1 dans lequel ladite composition initiatrice comprend un sel d'iodonium, ou un sel d'iodonium en combinaison avec un mercaptotriazole ou un métallocène, dans lequel ledit sel d'iodonium est éventuellement un borate d'iodonium.

4. Elément selon la revendication 1, dans lequel ledit liant polymère comprend des chaînes latérales de poly(éthylène glycol) et est présent au moins partiellement en tant que particules distinctes.

5. Elément imageable selon la revendication 1 qui est développable sur presse et dans lequel ladite composition initiatrice comprend un sel d'iodonium et un mercaptotriazole.

6. Elément imageable selon la revendication 1 qui est sensible au rayonnement d'imagerie ayant une longueur d'onde d'au moins 250 nm et jusqu'à 450 nm inclus, ledit composé d'absorption de rayonnement étant un dérivé de 2,4,5-triaryloxazole.

7. Elément imageable selon la revendication 1, dans lequel ledit substrat est un substrat contenant de l'aluminium anodisé à l'acide sulfurique.

8. Elément imageable selon la revendication 1 comprenant en outre un revêtement de surface imperméable à l'oxygène disposé sur ladite couche imageable.

9. Procédé de fabrication d'une plaque d'impression fonctionnant en négatif comprenant :
A) l'exposition conformément à une image d'un élément imageable fonctionnant en négatif selon l'une quelconque des revendications 1 à 8 à un rayonnement d'imagerie pour produire des régions exposées et non exposées dans chaque couche imageable, et
B) sans étape de préchauffage, le développement dudit élément exposé conformément à une image pour retirer uniquement lesdites régions non exposées de ladite couche imageable.

10. Procédé selon la revendication 9, dans lequel l'étape B est réalisée sur presse en présence d'une solution fontaine, d'une encre d'impression ou d'une combinaison de celles-ci.
